(19) Europäisches Patentamt
European Patent Office
Office européen des brevets

(11) **EP 2 788 784 B1**

(12) **EUROPEAN PATENT SPECIFICATION**

(45) Date of publication and mention
of the grant of the patent:
**04.10.2017 Bulletin 2017/40**

(51) Int Cl.:
***G01S 5/04*** *(2006.01)*    ***G06F 1/28*** *(2006.01)*
***H05K 7/14*** *(2006.01)*

(21) Application number: **11804842.0**

(22) Date of filing: **09.12.2011**

(86) International application number:
**PCT/US2011/064066**

(87) International publication number:
**WO 2013/085532 (13.06.2013 Gazette 2013/24)**

(54) **SYSTEM FOR LOCATING DEVICES IN A DATA CENTRE USING DIRECTIONAL ANTENNAS**

SYSTEM ZUR ORTUNG VON VORRICHTUNGEN MIT RICHTANTENNEN

SYSTÈME DE LOCALISATION DE DISPOSITIFS AU MOYEN D'ANTENNES DIRECTIONNELLES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.10.2014 Bulletin 2014/42**

(73) Proprietor: **Schneider Electric IT Corporation
West Kingston, RI 02892 (US)**

(72) Inventor: **WARE, Gary, R.
Newton, MA 02459 (US)**

(74) Representative: **Hayden, Nicholas Mark
Murgitroyd & Company
Scotland House
165-169 Scotland Street
Glasgow G5 8PL (GB)**

(56) References cited:
**GB-A- 2 383 708      US-A1- 2005 138 439
US-A1- 2006 167 624**

**Description**

BACKGROUND

Datacenters often include multiple equipment racks holding multiple servers or other computer equipment. Managers of data centers attempt to keep track of where each server is located in the datacenter to allow access to a specific server, for example in case of a server crash. However, servers and other computer equipment may be moved around the datacenter, and conventional tracking systems are typically manually updated, which frequently results in errors. Computer equipment may be difficult to locate if there are errors or delays in updating a manual tracking system, and the recorded location for a selected piece of equipment is incorrect.

US2005/138439 discloses system and method to determine a physical location of a blade server. US2006/167624 describes a system which automatically maps computer center rooms and locates data center components within computer centers. GB2383708 discloses a system which monitors the positions of players on a football pitch.

SUMMARY

The present invention is defined by the appended claims. According to one aspect, systems and methods for locating devices in a datacenter are provided. A method of locating a device in an equipment rack in a data center includes receiving a signal from the device at a master antenna unit positioned in the equipment rack, wherein the master antenna unit includes a first antenna and a second antenna, receiving the signal at a first child antenna unit positioned in the equipment rack, wherein the first child antenna unit includes a third antenna and a fourth antenna, comparing a relative strength of the signal at the first and second antennas to determine a first angle relative to a first axis of the equipment rack, said first angle relating to the bearing of the device relative to the master antenna unit, comparing the relative strength of the signal at the third and fourth antennas to determine a second angle relative to the first axis of the equipment rack, , said second angle relating to the bearing of the device relative to the first child antenna unit and determining a device location in the equipment rack using the first and second angles. Determining the device location in the equipment rack may include using triangulation.

In one embodiment, the method includes powering the master antenna unit from at least one of batteries and power from a USB outlet. In another embodiment, the method includes transmitting the device location to a data center manager device. According to one embodiment, the method also includes receiving the signal at a second child antenna unit positioned in the equipment rack, wherein the second child antenna unit includes a fifth antenna and a sixth antenna.

According to one embodiment, the master antenna unit also includes a fifth antenna and determining the first angle further includes comparing the relative strength of the signal at the fifth antenna unit. According to another embodiment, the first child antenna unit also includes a sixth antenna, and determining the second angle further includes comparing the relative strength of the signal at the sixth antenna.

In one embodiment, the method includes transmitting the signal from the device, wherein the signal is a short range wireless signal. In another embodiment, the method includes transmitting the signal from a transceiver attached to one of a datacenter device and a cable coupled to a datacenter device. In a further embodiment, the method includes transmitting the second angle to the master antenna unit.

According to one aspect, a system for locating a device in an equipment rack in a data center includes a master antenna unit, a first child antenna unit and a processor. The master antenna unit is positioned in the equipment rack and adapted to receive a signal from the device, said master antenna unit having an input to receive power and comprising at least a first antenna and a second antenna configured to detect the signal. The first child antenna unit is positioned in the equipment rack and adapted to receive the signal from the device, said child antenna unit having at least a third antenna and a fourth antenna configured to detect the signal. The processor is coupled to the master antenna unit and is configured to use data from the master antenna unit and the child antenna unit to determine the location of the device associated with the signal, by comparing a relative strength of the signal at the first and second antennas to determine a first angle relative to a first axis of the equipment rack, said first angle relating to the bearing of the device relative to the master antenna unit, and comparing the relative strength of the signal at the third and fourth antennas to determine a second angle relative to the first axis of the equipment rack, said second angle relating to the bearing of the device relative to the first child antenna unit.

According to one embodiment, the system also includes a short range wireless transmitter configured to transmit the transmitted signal. The transmitter may be configured to couple to a datacenter device or a cable coupled to the datacenter device. According to another embodiment, the system may include a second child antenna unit having at least two antennas configured to detect the transmitted signal and configured to transmit data to the master antenna unit. According to a further embodiment, the master antenna unit and the first child antenna unit are configured for mounting in an equipment rack of a data center.

Also disclosed is a method of locating a device in a data center includes receiving a signal from the device at a master antenna unit, wherein the master antenna unit includes a first antenna and a second antenna, receiving the signal at a first child antenna unit, wherein the first child antenna unit includes a third antenna and a fourth antenna, comparing a relative strength of the signal at the first and second antennas to determine a first angle relative to a first axis, comparing the relative strength of the signal at the third and fourth antennas to determine a second angle relative to the first axis, and determining a device location in the data center using triangulation and the first and second angles.

According to one embodiment, the method includes powering the master antenna unit from at least one of batteries and power from a USB outlet. In another embodiment, the method includes transmitting the device location to a data center manager device. According to a further embodiment, the method includes receiving the signal at a second child antenna unit, wherein the second child antenna unit includes a fifth antenna and a sixth antenna. According to another embodiment, the method includes transmitting the signal from a transceiver attached to one of a datacenter device and a cable coupled to a datacenter device.

BRIEF DESCRIPTION OF THE FIGURES

The accompanying drawings are not intended to be drawn to scale. In the drawings, each identical or nearly identical component that is illustrated in various figures is represented by a like numeral. For purposes of clarity, not every component may be labeled in every drawing. In the drawings:

FIG. 1 is a diagram of a datacenter rack including antennas in accordance with one embodiment of the invention;
FIG. 2 is a schematic diagram of two antennas identifying a selected location in accordance with one embodiment of the invention;
FIG. 3 is a schematic diagram showing triangulation of signal location;
FIG. 4 is a flow chart showing a method of identifying a device in a datacenter in accordance with one embodiment of the invention;
FIG. 5A is a schematic diagram of three sets of antennas used together to identify signal locations in accordance with one embodiment of the invention;
FIG. 5B is a schematic diagram of two sets of antennas used together to identify signal locations in accordance with one embodiment of the invention;
FIG. 6 is a schematic diagram showing three connected sets of antennas in accordance with one embodiment of the invention;
FIG. 7 is a schematic diagram showing an antenna in accordance with one embodiment of the invention;
FIG. 8 is a schematic diagram showing an antenna's area of reception in accordance with one embodiment of the invention;
FIG. 9A is a schematic diagram showing a detector in accordance with one embodiment of the invention;
FIG. 9B is a schematic diagram showing a network cord and a detector in accordance with one embodiment of the invention; and
FIG. 10 is a schematic diagram of wireless transceiver in accordance with one embodiment of the invention.

DETAILED DESCRIPTION

Embodiments of this invention are not limited in their application to the details of construction and the arrangement of components set forth in the following description or illustrated in the drawings. Embodiments of the invention are capable of other embodiments and of being practiced or of being carried out in various ways. Also, the phraseology and terminology used herein is for the purpose of description and should not be regarded as limiting. The use of "including," "comprising," or "having," "containing," "involving," and variations thereof herein, is meant to encompass the items listed thereafter and equivalents thereof as well as additional items. Any references to front and back, left and right, and top and bottom, are intended for convenience of description, not to limit the present systems and methods or their components to any one positional or spatial orientation.

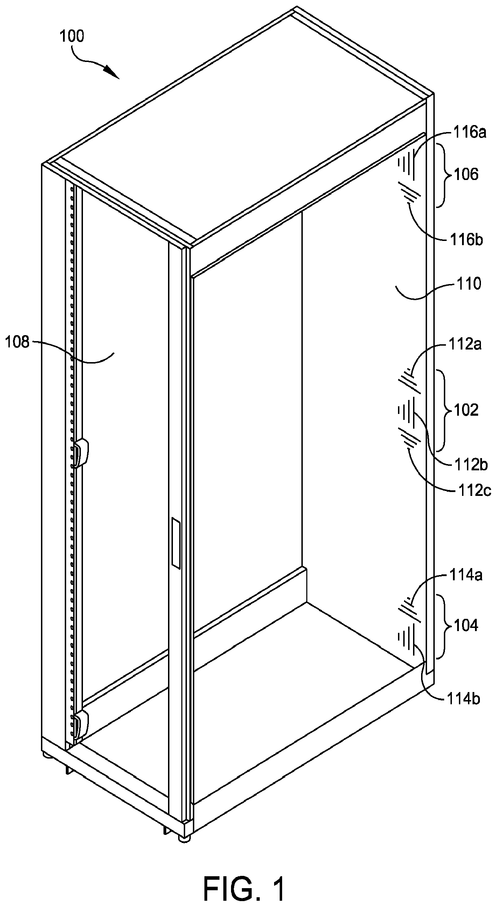

FIG. 1 is a diagram of a datacenter rack 100 including first 102, second 104 and third 106 sets of antennas, according to one embodiment of the invention. The first 102, second 104 and third 106 sets of antennas are attached to a side wall 110 of the rack 100. According to one feature, the side 108 is the front of the rack 100 and the antennas are attached to the rear of the side wall 110 of the rack 100. The first 102, second 104 and third 106 sets of antennas may be used to identify location and identity of servers or other equipment placed in the rack 100 by receiving a signal emitted from the server or equipment or from cables or devices coupled to the server or equipment.

The first set of antennas 102 is positioned in the center of the wall 110 of the rack 100 and includes three separate antennas 112a-112c positioned to receive signals emitted from devices placed in the rack 100. The second set of antennas 104 is positioned at the bottom of the wall 110 of the rack 100 and includes two separate antennas 114a-114b, positioned to receive signals from devices placed next to or above them. The third set of antennas 106 is positioned at the top of the wall 110 of the rack 100 and includes two separate antennas 116a-116b positioned to receive signals from devices placed next to or below them. The rack 100 is shown with no devices. However, multiple servers or other equipment may be placed in the rack 100, and mounted to mounting rails of the rack as is known. The placement of the antennas in the rear of the rack does not interfere with the mounting of the servers.

According to one aspect, a datacenter may include multiple racks 100 and each rack may be equipped with antennas. Additionally, antennas may be installed on the walls or other structures in a data center, to identify and locate racks in the data center.

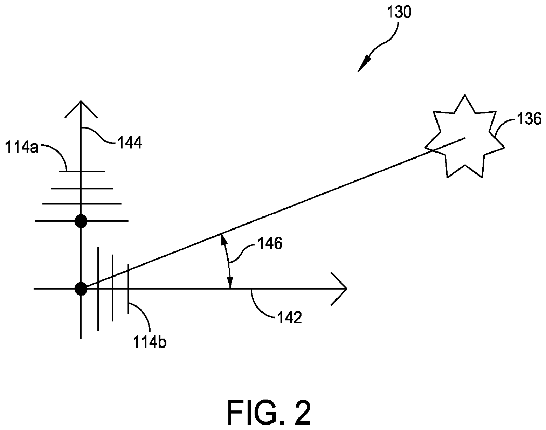

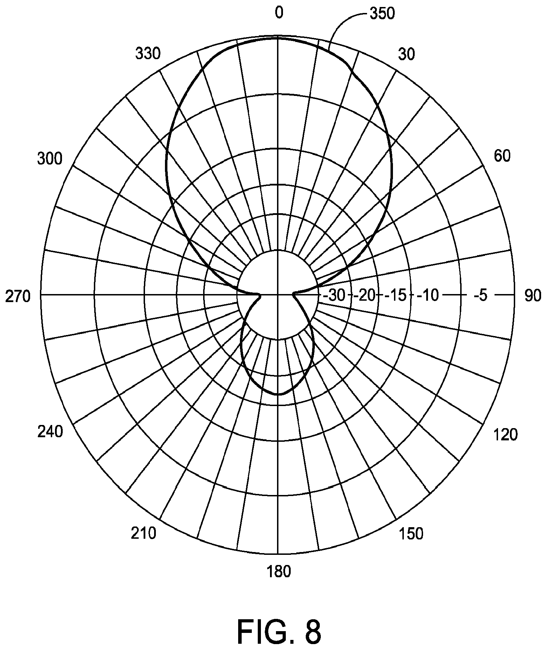

Operation of the antennas to determine the location of a device in a data center will now be disclosed. FIG. 2 is a schematic diagram 130 of first 114b and second 114a antennas. The first antenna 114b detects the strength of a signal along the x-axis 142, while the second antenna 114a detects the strength of the signal along the y-axis 144. Combining the two signal strengths, the angle 146 to the location 136 can be determined if the signal is located between the x-axis 142 and the y-axis 144 in the first quadrant, as shown in FIG. 2, and is within range of the antennas 114b and 114a, as discussed in greater detail below with respect to FIG. 8. In one example, if the signal is located in line with or below the x-axis 142, the signal strength at the second antenna 114a will be about zero. Similarly, in another example, if the signal is located in line with or behind the y-axis 144, the signal strength at the first antenna 114b will be about zero.

The angle 146 is determined by the ratio of the signal strength at the first antenna 114b to the signal strength at the second antenna 114a. Note that if the signal strengths are measured in decibels (dB), angle 146 from the x-axis is determined by the difference between the signal strengths. In one example, the first 114b and second 114a antennas have a received radiation pattern such as that shown in FIG. 8 and described below. Using the exemplary received radiation pattern of FIG. 8, Table 1 illustrates how the angle 146 from the x-axis can be determined from the difference in signal strengths at the first 114b and second 114a antennas.

**Table 1**

| Degrees from x-axis 142 (angle 146) | Amplitude at first antenna 114b (in dB) | Amplitude at second antenna 114a (in dB) | Difference (in dB) |
|---|---|---|---|
| 0 | 0.0 | -60.0 | -60.0 |
| 10 | -0.6 | -30.0 | -29.4 |
| 20 | -1.9 | -20.0 | -18.1 |
| 30 | -3.8 | -14.0 | -10.3 |
| 40 | -5.8 | -8.5 | -2.7 |
| 45 | -7.2 | -7.3 | -0.1 |
| 50 | -8.5 | -6.0 | 2.5 |
| 60 | -14.0 | -3.7 | 10.3 |
| 70 | -20.0 | -1.7 | 18.3 |
| 80 | -30.0 | -0.8 | 29.2 |
| 90 | -60.0 | 0.0 | 60.0 |

The angle 146 is calculated from the ratio of signal strengths at the first 114b and second 114a antennas.

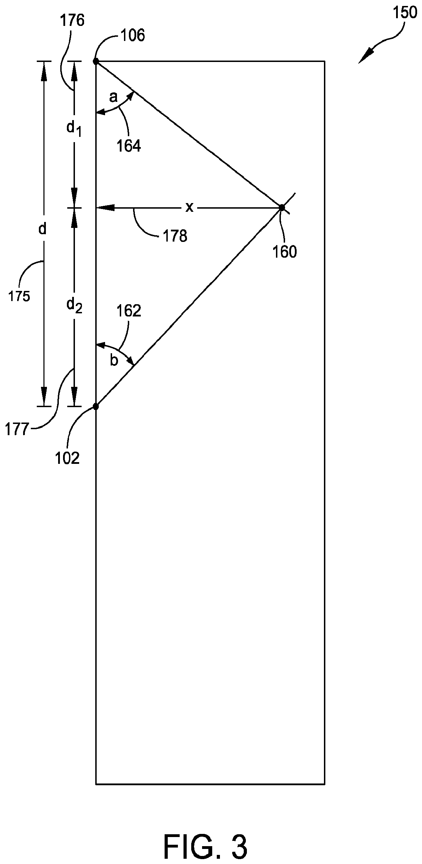

FIG. 3 is a schematic diagram 150 showing the two sets of antennas 102 and 106 from FIG. 1. The two sets of antennas 102 and 106 are used together to identify a signal location 160, according to an embodiment of the invention. A first angle 162 from the first set of antennas 102 can be interpolated from the ratio of the signal strength at the first antenna 112a to the signal strength at the second antenna 112b. The second angle 164 from the third set of antennas 106 can be interpolated from the ratio of the signal strength at the third antenna 116a to the signal strength at the fourth antenna 116b. Using the first 162 and second 164 angles the horizontal and vertical signal location 166 can be calculated with triangulation.

As will now be described, the angles 62 and 164, calculated as described above, can be used to determine the signal location 160. In particular, the tangent of the angle 164 ("a") is equal to the ratio of the distance 178 ("x") between the vertical axis and the signal location 160 to the distance 176 between the first set of antennas 106 and the signal location along the vertical axis ("$d_1$"):

$$\frac{x}{d_1} = \text{Tan (a)} \tag{1}$$

Thus, the distance of the signal location from the top of the rack 176 ("$d_1$") is:

$$d_1 = \frac{x}{\text{Tan (a)}} \tag{2}$$

The distance 178 ("x") of the signal location 160 from the vertical axis can be determined using the angle 162 between the vertical axis at the first set of antennas 102 and the signal location 160, the angle 164 between the vertical axis at the third set of antennas 106 and the signal location 160, and the distance 175 ("d") between the first set of antennas 102 and the third set of antennas 106. In particular, because

$$d = d_1 + d_2 \tag{3}$$

therefore:

$$d = \frac{x}{\text{Tan (a)}} + \frac{x}{\text{Tan (b)}} \tag{4}$$

Rewriting this equation to solve for x, the distance 178 ("x") from the vertical axis to the signal location 160 equals:

$$x = \frac{d}{\dfrac{1}{\text{Tan (a)}} + \dfrac{1}{\text{Tan (b)}}} \tag{5}$$

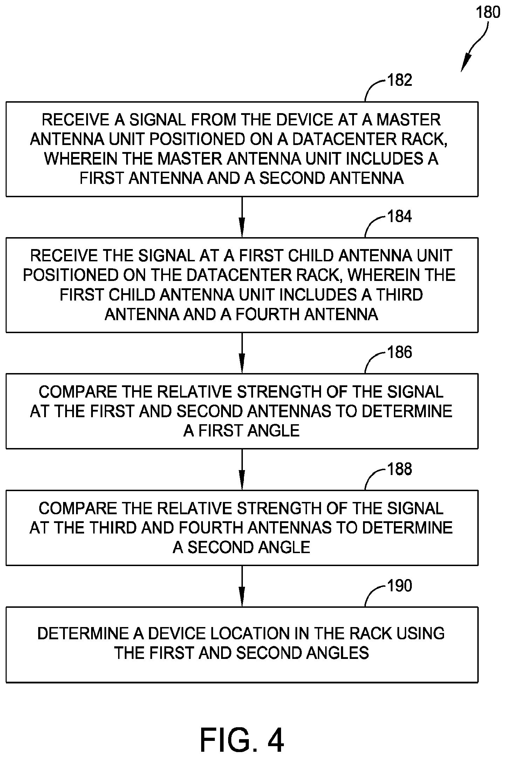

A method 180 of locating a device in an equipment rack in a data center using antennas positioned in an equipment rack using the concepts above will now be discussed with reference to FIG. 4. At 182, the method includes the act of a master antenna unit positioned on an equipment rack receiving a signal from the device. The master antenna unit includes a first antenna and a second antenna. At 184, a first child antenna unit positioned on the datacenter rack receives the signal from the device. The first child antenna unit includes a third antenna and a fourth antenna. At 186, the relative strength of the signal at the first and second antennas is compared to determine a first angle. The first angle is the angle between an axis defined by the side of the datacenter rack and a line between the master antenna unit and the device. At 188, the relative strength of the signal at the third and fourth antennas is compared to determine a second angle. The first angle is the angle between an axis defined by the side of the datacenter rack and a line between the master antenna unit and the device. At 190, a device location in the equipment rack is determined using triangulation and the first and second angles, as described above.

According to one embodiment, the master antenna unit communicates with a coordinator which communicates with the antenna units and the devices in the rack. The coordinator may be an Ethernet bridge, and it may communicate with the master antenna unit and the child antenna units through a wired or wireless connection. The coordinator may receive power through AC mains, battery, or through a USB port of a device in the rack. The coordinator may communicate with one or more of rack power distribution units, Network Management Cards, and networked cameras and other security monitoring devices. A Network Management Card may send data to one or more or an Ethernet connection and a serial connection.

According to one embodiment, the coordinator may instruct the devices in a rack to transmit a signal periodically at a predetermined time. The coordinator may also instruct the antenna units to wake up and receive data at the predetermined time. Thus, the coordinator arranges for the antenna units to wake up just before the devices transmit a signal time, and then receive transmitted data from all the devices in the rack at the predetermined time. In between the predetermined times, the antenna units may be in a low power sleep mode, thereby saving energy.

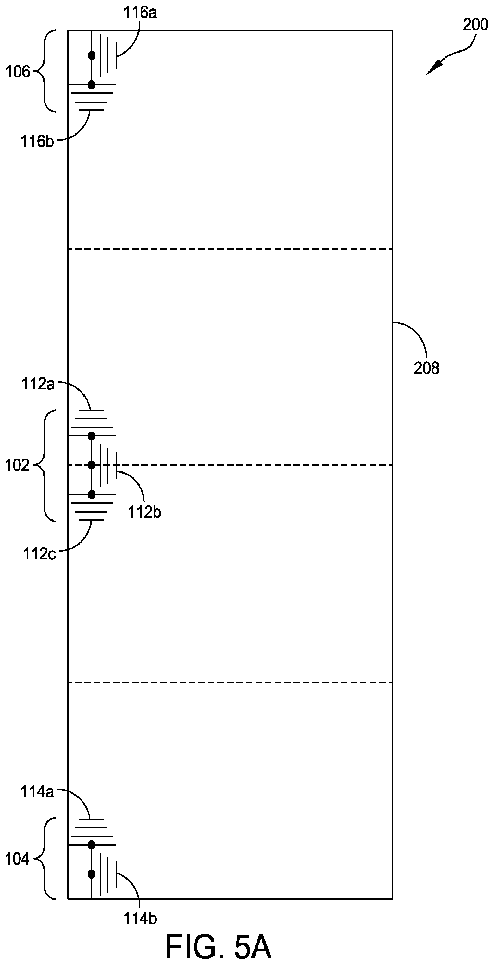

FIG. 5A is a two dimensional schematic diagram of three sets of antennas 102, 104 and 106 used together to identify a location of sources of signals within a rack 208, according to an embodiment of the invention. The first set of antennas 102 includes three antennas 112a-112c and is positioned in the center of one side of the rack 208. The first antenna 112a receives signals from devices in the top half of the rack 208, the second antenna 112b receives signals from devices in the middle of the rack 208, and the third antenna 112c receives signals from devices in the bottom of the rack 208. The second set of antennas 104 includes two antennas 114a-114b and is positioned in the bottom left-hand corner of the rack 104. The antennas 114a and 114b both receive signals from devices in the rack 208 at varying signal strengths, as described with respect to the antennas 114b and 114a of FIG. 2. Similarly, the third set of antennas 106 includes two antennas 116a-116b and is positioned in the top left-hand corner of the rack 104, and the antennas 116a and 116b both receive signals from devices in the rack 208 at varying signal strengths, as described with respect to the antennas 114b and 114a of FIG. 2. The various antennas 112a-112c, 114a-114b and 116a-116c may be used to determine the location of a signal source in the rack 208, for example using triangulation as described above. According to other embodiments, one or more of the sets of antennas 102, 104 and 106 may be positioned on the right-hand side of the rack 208. In a further embodiment, additional sets of antennas may be positioned on the right-hand side of the rack 208.

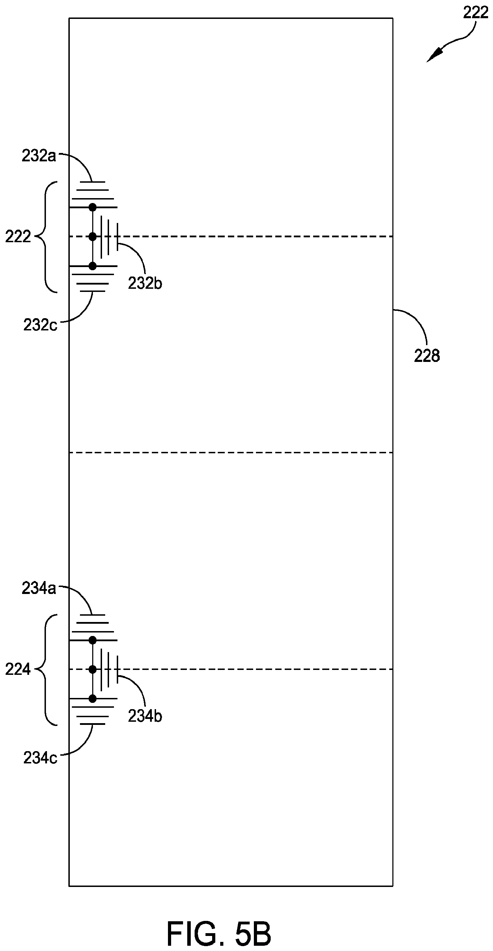

In another embodiment, as shown in FIG. 5B, two sets 222 and 224 of three antennas may be used together to identify a location of sources of signals. The first 222 and second 224 sets of antennas are positioned along the left-hand side of the rack 228. The first set of antennas 222 includes three antennas 232a-232c and is positioned in the top half of the rack 228. The second set of antennas 224 includes three antennas 234a-234c and is positioned in the bottom half of the rack 228. Each of the first 222 and second 224 sets of antennas receives signals from any place within the rack 228, and the received signal strengths at the various antennas 232a-232c and 234a-234c can be used to determine the location of a source of a signal within the rack 228, as described above with respect to FIG. 3B. According to other embodiments, one or more of the sets of antennas 222 and 224, and the sets of antennas 102, 104 and 106 of FIG. 5A may be positioned on the right-hand side of the rack 228. In a further embodiment, additional sets of antennas may be positioned on the right-hand side of the rack 228.

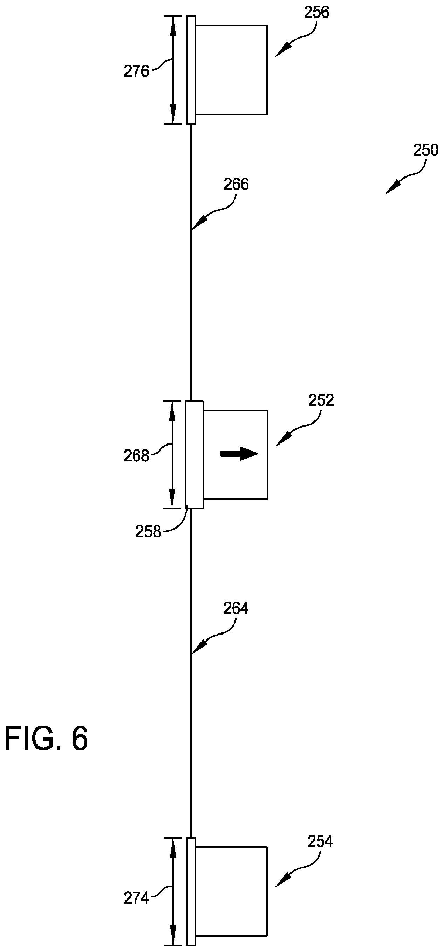

FIG. 6 is a schematic diagram of a system 250 for detecting the location of devices in a rack in accordance with one embodiment of the invention. The system 250 includes three connected sets of antennas, including a master antenna unit 252 and first 254 and second 256 child antenna units. The master antenna unit 252 includes one or more individual antennas as described above with respect to FIGS. 1-3 and 5A-5B, and is coupled to a base 258. The base 258 may include a USB port which collects the received signal data. The base may process the received signal data, or it may transmit the received signal data to an external processor for analysis. In one embodiment, the base provides power to the master antenna unit 252. In another embodiment, the master antenna unit 252 is powered by batteries, for example, one or more AA or AAA batteries. In another embodiment, the master antenna unit 252 is powered by AC mains power. In a further embodiment, the master antenna unit 252 receives power from a Power Over Ethernet (POE) connection. The antenna units 252, 254 and 256 may each include a U pointer indicating the vertical position of the antenna unit in the rack. In one example, an equipment rack includes forty U spaces (or unit spaces), and the master antenna unit 252 is positioned at U space 20. In another example, the first child antenna unit 254 is positioned at the bottom of an equipment rack at U space 1, and the second child antenna unit 256 is positioned at the top of an equipment rack at U space 40.

As shown in the illustrative embodiment, the first 254 and second 256 child antenna units are coupled to the base 258 via first 264 and second 266 cables. The first 254 and second 256 child antenna units transmit received signal data to the base 258. In other embodiments, the first 254 and second 256 child antennas may be wirelessly coupled to the base 258. In one embodiment, the base 258 provides power to the first 254 and second 256 child antenna units. In another embodiment, the first 254 and second 256 child antenna units receive battery power from the master antenna unit 252. In a further embodiment, the base of each of the first 254 and second 256 child antenna units includes a battery to power the first 254 and second 256 child antenna units. In one example, the length 268 of the master antenna unit 252 is about 25 cm, and the lengths 274 and 276 of the first 254 and second 256 child antenna units is about 15 cm. In a further embodiment, the base 258 receives power from a USB connection to a computer or from a USB connection to a wall-mounted power supply, and the base 258 may provide power to the first 254 and second 256 child antenna units.

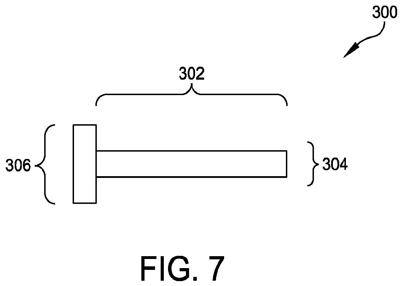

FIG. 7 is a schematic diagram showing a top view of an antenna 300, according to an embodiment of the invention. According to one example, the antenna 300 has a length 302 of about 75 mm, a width 304 of about 5 mm, and is attached to a base with a width 306 of about 25 mm.

According to one embodiment, the antennas positioned in the datacenter rack, as described above, are directional antennas. In one example, the antennas are Yagi antennas. FIG. 8 is a schematic diagram showing the area of reception 350 of a Yagi antenna used in an embodiment of the invention. The diagram shows the 360 degrees of a circle, and the area of reception 350 of an antenna positioned at the center of the axes and directed toward 0 degrees. The antenna detects signals transmitted from within the area of reception 350, and the relative strengths of the received signals depend on the signal's location within the area of reception 350, with signal strength decreasing with increased angle with respect to the center line of the antenna. As shown in FIG. 8, the antennas used are highly directional which enables systems of the invention to accurately locate transmitting devices in data center racks.

In various embodiments, the transmitted signal may be sent from a transceiver externally coupled to equipment in a rack to allow the systems described above to determine the location of the equipment in the rack. In different embodiments, the transceivers may be contained in a USB device or in a cable or connector coupled to the device. Two exemplary devices including transceivers are described in U.S. Patent Application Serial No. 13/193,109 and U.S. Patent Application Serial No. 13/194,484, which are assigned to the assignee of the present application. In one embodiment, the transceiver is contained in a network cable coupled to the equipment.

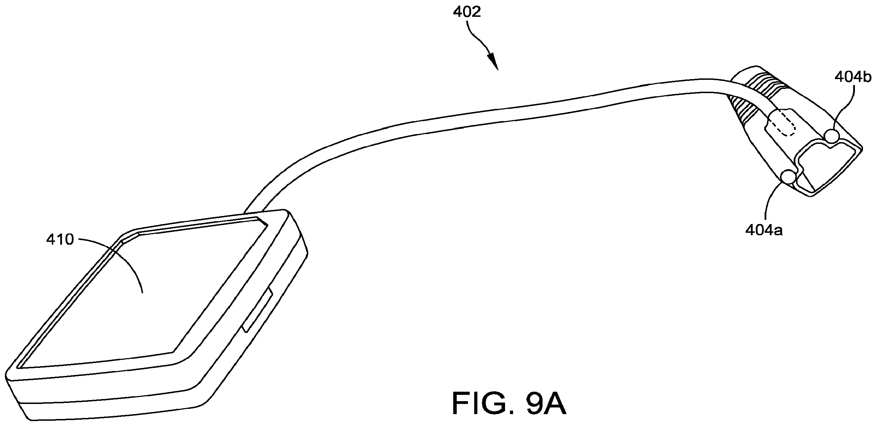

FIG. 9A is a schematic diagram showing a detector 402, according to an embodiment of the invention. The detector 402 includes a housing that slides over a network cable and a battery-powered radio that may be attached to a rack-mounted device. As is known, many network capable devices include LED's on either side of the network cable latch. The detector 402 functions to detect network activity by monitoring link and status LED's at the network cable latch. In one embodiment, a predetermined pattern of traffic is transmitted to a selected IP address and the detector 402 will report the pattern detected at the rack-mounted device. If the predetermined pattern of traffic matches the pattern detected at the rack-mounted device, the detector 402 is associated with the IP address of the device. In one example, the detector 402 includes an RFID tag. In another example, the detector 402 includes a Zigbee transmitter, which may be used to locate the detector 402.

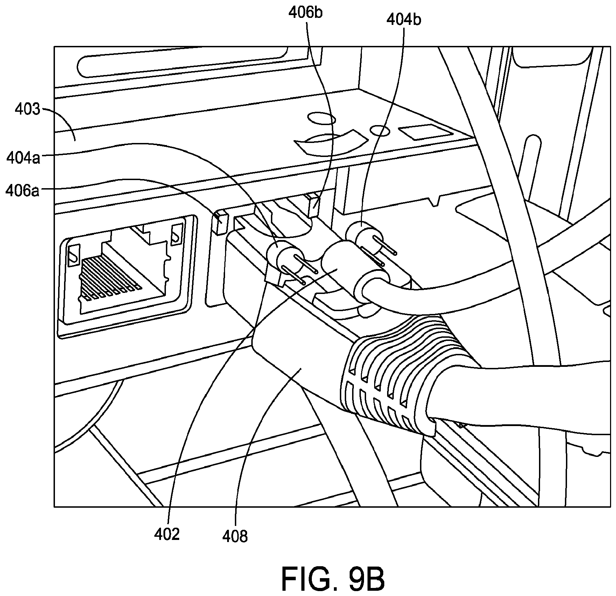

FIG. 9B is a schematic diagram showing a network cable 408 that includes the detector 402, according to an embodiment of the invention. The network cable 408 may be an Ethernet cable, such as an Ethernet RJ45 cable. The network cable is shown plugged into a rack-mounted device 403. The housing that slides over the cable may be soft or rigid. The detector 402 includes clip-on photo sensors 404a-404b. The photo sensors 404a-404b are positioned on the top of the detector 402 and line up with the LEDs 406a-406b. One of the two LEDs on either side of the network cable latch flashes when there is network activity between the device and the network. The detector 402 determines which LED 406a-406b flashes due to network activity and ignores the other LED 406a-406b. In particular, the photo sensors 404a-404b detect when the LED's 406a-406b are on or off, detecting activity profile of the LED's 406a-406b, which indicates the network activity profile of the device 403. According to one feature, the photo sensors 404a-404b do not obstruct the visibility of the LEDs 406a-406b. In one embodiment, the detector 402 includes a transmitter and transmits detected activity data, which may be received by antennas associated with location systems of embodiments of the invention. In another embodiment, the detector 402 may transmit detected activity to asset management software installed on a datacenter management device. The datacenter management device may be used by a datacenter manager to identify and locate computer equipment in the datacenter.

In one embodiment, to locate a device in the datacenter, the asset management software may artificially cause a pattern of bursts of traffic to a selected IP address during a period of low traffic. Using detectors, the asset management software identifies which detector 402 reports a similar pattern. It one example, the asset management software may subsequently confirm the association with a different pattern. The detector 402 may include an active RFID tag which may be used to locate the detector 402 when the equipment is removed from the room, out of view of the antennas and the data center manager.

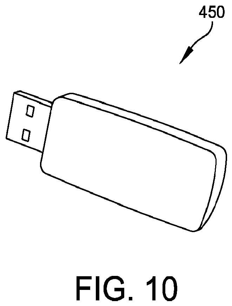

FIG. 10 is a schematic diagram of a wireless transceiver 450, used with device location systems of embodiments of the invention. The wireless transceiver 450 may be plugged into a server or other computer equipment in a datacenter rack. The server or equipment may transmit static and/or dynamic information to the transceiver 450. The transceiver 450 wirelessly transmits a signal including its identification and the identification of the server or computer equipment to which it is coupled. The transceiver 450 may be a Zigbee® transceiver or a Bluetooth transceiver. Location systems described above can receive the transmitted signal, identify the device from the signal, and using the processes described above, determine the location of the device in the rack.

According to one embodiment, asset management software may also associate metered power cords with the server. In one example, the asset management software detects large aberrations in power consumption, as recorded by the metered power cords. In some examples, large aberrations in power consumption may be caused by server reboots or changes in load by about 25% or more. The asset management software may correlate the power consumption information to network protocol information, indicating, for example, that a selected device was rebooted, thereby associating the power cord with the device to which it is coupled.

According to another embodiment, information about IP and MAC address vs. server serial number may be determined over the network through protocols (both existing and emerging) embedded in the server hardware. One example of an existing protocol is the Intelligent Platform Management Interface. An example of an emerging protocol is the Intel® Data Center Manager™. The protocol may be designed to measure and control temperature and power usage. The IP address of a device may be used to access the Intelligent Platform Management Interface or the Data Center Manager. In one example, traffic-pattern correlation, as described above with respect to FIGS. 9A and 9B may be used to identify the IP address of a device and access the Intelligent Platform Management Interface or the Data Center Manager. In one embodiment, systems and methods are provided to associate a server's unique identification information with the server's location. The server's unique identification information may include one or more of its serial number, IP address and host name.

The systems and methods disclosed herein may provide an automated, easy to use, on location system for locating devices in a datacenter. The systems can identify which equipment rack in a data center contains a particular device and can determine the location in the equipment rack of the device. In one embodiment, one or more antenna sets are positioned in datacenter racks for locating signals transmitted from devices in the rack. The antenna sets each include one or more antennas. Child antenna sets may be coupled to a master antenna set. The master antenna set may include a processing module for determining the location of transmitted signals based on data received at the child and master antenna sets, or the master antenna set may transmit the received data to a processor. In one embodiment, a datacenter includes antenna sets mounted around the datacenter, for example on the datacenter walls, which may be used to locate the rack in the datacenter in which a selected device is positioned. The antennas mounted on the rack may then be used to locate the selected device in the rack.

The embedded measurements, algorithms and calculations of data disclosed herein may be configured to provide recommendations for optimal configuration of power or network connections of attached equipment and other recommendations as described herein. Embodiments may include utilizing communication methods from external devices. Such external devices may include other rack PDU's, other hardware (e.g., remote power panels or feeder PDU's), and/or other external software, such as APC Infrastruxure Central offered by American Power Conversion Corporation of West Kingston, Rhode Island, or third party applications, and processing of this data embedded into the rack PDU itself to provide user recommendations and/or calculated data based on the external information and the data collected within the rack PDU itself. Embodiments may further include a display built into the rack PDU, such as LCD, LED, or other type of display, and any associated user interface which may be interactive to display measurements or recommendations real time to a user at the rack PDU. Alternative embodiments may include an optional external display connected directly to the rack PDU, such as LCD, LED, or other type of display, and any associated user interface which may be interactive to display the measurements or recommendations real-time to a user at the rack PDU. Methods to transmit this data to remote locations via an embedded web interface, SNMP, serial, or any other communication method of the information processed in the rack PDU to other devices may further be provided.

In certain embodiments, the measurements may be logged in an embedded memory of a network management card of the PDU, for example, for data analysis purposes. Operators may utilize the measurement data, particularly the current and power data, in order to achieve certain performance improvements. For example, such measurement data may be used to monitor the current draw to avoid circuit overloads. Another use for measurement data may be to track power usage for capacity or cooling planning.

Having thus described several aspects of at least one embodiment of this invention, it is to be appreciated various alterations, modifications, and improvements will readily occur to those skilled in the art. Such alterations, modifications, and improvements are intended to be part of this disclosure, and are intended to be within the scope of the invention. For example, alternative configurations of electrical components may be utilized to produce similar functionality, for example, transceiver functions, or other functions. Accordingly, the foregoing description and drawings are by way of example only.

**Claims**

1. A method (180) of locating a device in an equipment rack (100) in a data center, comprising:

   receiving (182) a signal from the device at a master antenna unit (102, 222, 252) positioned in the equipment rack, wherein the master antenna unit includes a first antenna (112a, 112c, 232b) and a second antenna (112b, 232a, 232c);
   receiving (184) the signal at a first child antenna unit (104,106, 254, 256, 224) positioned in the equipment rack, wherein the first child antenna unit includes a third antenna (114a, 116b, 234b) and a fourth antenna (114b, 116a, 234a, 234c);
   comparing (186) a relative strength of the signal at the first and second antennas to determine a first angle (b) relative to a first axis of the equipment rack, said first angle relating to the bearing of the device relative to the master antenna unit;
   comparing (188) the relative strength of the signal at the third and fourth antennas to determine a second angle (a) relative to the first axis of the equipment rack, said second angle relating to the bearing of the device relative to the first child antenna unit; and
   determining (190) a device location (136, 160) in the equipment rack using the first and second angles.

2. The method of claim 1, wherein determining the device location in the equipment rack comprises using triangulation.

3. The method of claim 1, further comprising powering the master antenna unit from at least one of batteries and power from a USB outlet.

4. The method of claim 1, further comprising transmitting the device location to a data center manager device.

5. The method of claim 1, further comprising receiving the signal at a second child antenna unit (104,106, 254, 256) positioned in the equipment rack, wherein the second child antenna unit includes a fifth antenna (116b, 114a) and a sixth antenna (116a, 114b).

6. The method of claim 1, wherein the master antenna unit further includes a fifth antenna (232a, 232c) and wherein determining the first angle further includes comparing the relative strength of the signal at the fifth antenna.

7. The method of claim 6, wherein the first child antenna unit further includes a sixth antenna (234a, 234b), and wherein determining the second angle further includes comparing the relative strength of the signal at the sixth antenna.

8. The method of claim 1, further comprising transmitting the signal from the device, wherein the signal is a short range wireless signal.

9. The method of claim 1, further comprising transmitting the signal from a transceiver (450) attached to one of a datacenter device and a cable coupled to a datacenter device.

10. The method of claim 9, further comprising
receiving, at the transceiver, dynamic information about the datacenter device; and
transmitting, from the transceiver, the dynamic information.

11. A system for locating a device in an equipment rack in a data center, comprising:

a master antenna unit (102, 222, 252) positioned in the equipment rack and adapted to receive a signal from the device, said master antenna unit having an input to receive power and comprising at least a first antenna (112a, 112c, 232b) and a second antenna (112b, 232a, 232c) configured to detect the signal;
a first child antenna unit (104,106, 254, 256, 224) positioned in the equipment rack and adapted to receive the signal from the device, said child antenna unit having at least a third antenna (114a, 116b, 234b) and a fourth antenna (114b, 116a, 234a, 234c) configured to detect the signal;
a processor coupled to the master antenna unit and configured to use data from the master antenna unit and the child antenna unit to determine the location of the device associated with the signal by comparing (186) a relative strength of the signal at the first and second antennas to determine a first angle (b) relative to a first axis of the equipment rack, said first angle relating to the bearing of the device relative to the master antenna unit, and comparing (188) the relative strength of the signal at the third and fourth antennas to determine a second angle (a) relative to the first axis of the equipment rack, said second angle relating to the bearing of the device relative to the first child antenna unit.

12. The system of claim 11, further comprising a short range wireless transmitter configured to transmit the transmitted signal.

13. The system of claim 12, wherein the transmitter is configured to couple to one of a datacenter device and a cable coupled to the datacenter device.

14. The system of claim 11, further comprising a second child antenna unit (104,106, 254, 256) having at least two antennas (114a, 114b, 116a, 116b) configured to detect the transmitted signal and configured to transmit data to the master antenna unit.

15. The system of claim 11, wherein the master antenna unit and the first child antenna unit are configured for mounting in an equipment rack (100) of a data center.

**Patentansprüche**

1. Ein Verfahren (180) für die Standortfestlegung einer Vorrichtung in einem Geräteträger (100) in einem Rechenzentrum, das Folgendes beinhaltet:

    Empfangen (182) eines Signals von der Vorrichtung an einer in dem Geräteträger positionierten Gemeinschaftsantenneneinheit (102, 222, 252), wobei die Gemeinschaftsantenneneinheit eine erste Antenne (112a, 112c, 232b) und eine zweite Antenne (112b, 232a, 232c) umfasst;

    Empfangen (184) des Signals an einer ersten Nachfolgerantenneneinheit (104, 106, 254, 256, 224), die in dem Geräteträger positioniert ist, wobei die erste Nachfolgerantenneneinheit eine dritte Antenne (114a, 116b, 234b) und eine vierte Antenne (114b, 116a, 234a, 234c) umfasst;

    Vergleichen (186) einer relativen Stärke des Signals an der ersten und zweiten Antenne, um einen ersten Winkel (b) relativ zu einer ersten Achse des Geräteträgers zu bestimmen, wobei sich der erste Winkel auf die Lage der Vorrichtung relativ zu der Gemeinschaftsantenneneinheit bezieht;

    Vergleichen (188) der relativen Stärke des Signals an der dritten und vierten Antenne, um einen zweiten Winkel (a) relativ zu der ersten Achse des Geräteträgers zu bestimmen, wobei sich der zweite Winkel auf die Lage der Vorrichtung relativ zu der ersten Nachfolgerantenneneinheit bezieht; und

    Bestimmen (190) eines Vorrichtungsstandorts (136, 160) in dem Geräteträger unter Verwendung des ersten und zweiten Winkels.

2. Verfahren gemäß Anspruch 1, wobei das Bestimmen des Vorrichtungsstandorts in dem Geräteträger das Verwenden von Triangulation beinhaltet.

3. Verfahren gemäß Anspruch 1, ferner beinhaltend das Bestromen der Gemeinschaftsantenneneinheit mittels mindestens einem von Batterien und Strom von einem USB-Ausgang.

4. Verfahren gemäß Anspruch 1, ferner beinhaltend das Übertragen des Vorrichtungsstandorts an eine Rechenzentrumsverwaltungsvorrichtung.

5. Verfahren gemäß Anspruch 1, ferner beinhaltend das Empfangen des Signals an einer zweiten Nachfolgerantenneneinheit (104, 106, 254, 256), die in dem Geräteträger positioniert ist, wobei die zweite Nachfolgerantenneneinheit eine fünfte Antenne (116b, 114a) und eine sechste Antenne (116a, 114b) umfasst.

6. Verfahren gemäß Anspruch 1, wobei die Gemeinschaftsantenneneinheit ferner eine fünfte Antenne (232a, 232c) umfasst und wobei das Bestimmen des ersten Winkels ferner das Vergleichen der relativen Stärke des Signals an der fünften Antenne umfasst.

7. Verfahren gemäß Anspruch 6, wobei die erste Nachfolgerantenneneinheit ferner eine sechste Antenne (234a, 234b) umfasst und wobei das Bestimmen des zweiten Winkels ferner das Vergleichen der relativen Stärke des Signals an der sechsten Antenne umfasst.

8. Verfahren gemäß Anspruch 1, ferner beinhaltend das Übertragen des Signals von der Vorrichtung, wobei das Signal ein Kurzstrecken-Funksignal ist.

9. Verfahren gemäß Anspruch 1, ferner beinhaltend das Übertragen des Signals von einem Transceiver (450), der an einem von einer Rechenzentrumsvorrichtung und einem Kabel, das an die Rechenzentrumsvorrichtung gekoppelt ist, angebracht ist.

10. Verfahren gemäß Anspruch 9, das ferner Folgendes beinhaltet:

    Empfangen von dynamischen Informationen über das Rechenzentrum an dem Transceiver; und
    Übertragen der dynamischen Informationen von dem Transceiver.

11. Ein System für die Standortfestlegung einer Vorrichtung in einem Geräteträger in einem Rechenzentrum, das Folgendes beinhaltet:

    eine Gemeinschaftsantenneneinheit (102, 222, 252), die in dem Geräteträger positioniert ist und angepasst ist, um ein Signal von der Vorrichtung zu empfangen,

wobei die Gemeinschaftsantenneneinheit einen Eingang zum Empfangen von Strom aufweist und mindestens eine erste Antenne (112a, 112c, 232b) und eine zweite Antenne (112b, 232a, 232c) beinhaltet, die konfiguriert sind, um das Signal zu detektieren;

eine erste Nachfolgerantenneneinheit (104, 106, 254, 256, 224), die in dem Geräteträger positioniert ist und angepasst ist, um das Signal von der Vorrichtung zu empfangen, wobei die Nachfolgerantenneneinheit mindestens eine dritte Antenne (114a, 116b, 234b) und eine vierte Antenne (114b, 116a, 234a, 234c) aufweist, die konfiguriert sind, um das Signal zu detektieren;

einen Prozessor, der an die Gemeinschaftsantenneneinheit gekoppelt ist und konfiguriert ist, um Daten von der Gemeinschaftsantenneneinheit und der Nachfolgerantenneneinheit zu verwenden, um den Standort der mit dem Signal assoziierten Vorrichtung zu bestimmen, indem eine relative Stärke des Signals an der ersten und der zweiten Antenne verglichen (186) wird, um einen ersten Winkel (b) relativ zu einer ersten Achse des Geräteträgers zu bestimmen, wobei sich der erste Winkel auf die Lage der Vorrichtung relativ zu der Gemeinschaftsantenneneinheit bezieht, und die relative Stärke des Signals an der dritten und vierten Antenne verglichen wird (188), um einen zweiten Winkel (a) relativ zu der ersten Achse des Geräteträgers zu bestimmen, wobei sich der zweite Winkel auf die Lage der Vorrichtung relativ zu der ersten Nachfolgerantenneneinheit bezieht.

12. System gemäß Anspruch 11, ferner beinhaltend einen Kurzstrecken-Funksender, der konfiguriert ist, um das übertragene Signal zu übertragen.

13. System gemäß Anspruch 12, wobei der Sender konfiguriert ist, um an eines von einer Rechenzentrumsvorrichtung und einem Kabel, das an die Rechenzentrumvorrichtung gekoppelt ist, gekoppelt zu werden.

14. System gemäß Anspruch 11, ferner beinhaltend eine zweite Nachfolgerantenneneinheit (104, 106, 254, 256) mit mindestens zwei Antennen (114a, 114b, 116a, 116b), die konfiguriert sind, um das übertragene Signal zu detektieren, und konfiguriert sind, um Daten an die Gemeinschaftsantenneneinheit zu übertragen.

15. System gemäß Anspruch 11, wobei die Gemeinschaftsantenneneinheit und die erste Nachfolgerantenneneinheit konfiguriert sind, um in einem Geräteträger (100) einer Rechenzentrumvorrichtung montiert zu werden.

**Revendications**

1. Une méthode (180) de positionnement d'un dispositif dans un bâti d'équipement (100) dans un centre de données, comprenant :

la réception (182) d'un signal provenant du dispositif au niveau d'une unité d'antenne maître (102, 222, 252) située dans le bâti d'équipement, l'unité d'antenne maître incluant une première antenne (112a, 112c, 232b) et une deuxième antenne (112b, 232a, 232c) ;

la réception (184) du signal au niveau d'une première unité d'antenne enfant (104, 106, 254, 256, 224) située dans le bâti d'équipement, la première unité d'antenne enfant incluant une troisième antenne (114a, 116b, 234b) et une quatrième antenne (114b, 116a, 234a, 234c) ;

la comparaison (186) d'une force relative du signal au niveau des première et deuxième antennes afin de déterminer un premier angle (b) relativement à un premier axe du bâti d'équipement, ledit premier angle ayant trait au support du dispositif relativement à l'unité d'antenne maître ;

la comparaison (188) de la force relative du signal au niveau des troisième et quatrième antennes afin de déterminer un deuxième angle (a) relativement au premier axe du bâti d'équipement, ledit deuxième angle ayant trait au support du dispositif relativement à la première unité d'antenne enfant ; et

la détermination (190) d'une position de dispositif (136, 160) dans le bâti d'équipement en utilisant les premier et deuxième angles.

2. La méthode de la revendication 1, dans laquelle la détermination de la position de dispositif dans le bâti d'équipement comprend l'utilisation d'une triangulation.

3. La méthode de la revendication 1, comprenant en outre l'alimentation de l'unité d'antenne maître à partir d'au moins soit des batteries, soit une alimentation provenant d'une sortie USB.

4. La méthode de la revendication 1, comprenant en outre la transmission de la position de dispositif à un dispositif gestionnaire de centre de données.

5. La méthode de la revendication 1, comprenant en outre la réception du signal au niveau d'une deuxième unité d'antenne enfant (104, 106, 254, 256) située dans le bâti d'équipement, la deuxième unité d'antenne enfant incluant une cinquième antenne (116b, 114a) et une sixième antenne (116a, 114b).

6. La méthode de la revendication 1, dans laquelle l'unité d'antenne maître inclut en outre une cinquième antenne (232a, 232c) et dans laquelle la détermination du premier angle inclut en outre la comparaison de la force relative du signal au niveau de la cinquième antenne.

7. La méthode de la revendication 6, dans laquelle la première unité d'antenne enfant inclut en outre une sixième antenne (234a, 234b), et dans laquelle la détermination du deuxième angle inclut en outre la comparaison de la force relative du signal au niveau de la sixième antenne.

8. La méthode de la revendication 1, comprenant en outre la transmission du signal provenant du dispositif, le signal étant un signal sans fil à faible portée.

9. La méthode de la revendication 1, comprenant en outre la transmission du signal provenant d'un émetteur-récepteur (450) attaché soit à un dispositif de centre de données, soit à un câble couplé à un dispositif de centre de données.

10. La méthode de la revendication 9, comprenant en outre
la réception, au niveau de l'émetteur-récepteur, d'informations dynamiques au sujet du dispositif de centre de données ; et
la transmission, à partir de l'émetteur-récepteur, des informations dynamiques.

11. Un système pour positionner un dispositif dans un bâti d'équipement dans un centre de données, comprenant :

une unité d'antenne maître (102, 222, 252) située dans le bâti d'équipement et conçue pour recevoir un signal provenant du dispositif, ladite unité d'antenne maître ayant une entrée pour recevoir une alimentation et comprenant au moins une première antenne (112a, 112c, 232b) et une deuxième antenne (112b, 232a, 232c) configurées pour détecter le signal ;
une première unité d'antenne enfant (104,106, 254, 256, 224) située dans le bâti d'équipement et conçue pour recevoir le signal provenant du dispositif, ladite unité d'antenne enfant ayant au moins une troisième antenne (114a, 116b, 234b) et une quatrième antenne (114b, 116a, 234a, 234c) configurées pour détecter le signal ;
un processeur couplé à l'unité d'antenne maître et configuré pour utiliser des données provenant de l'unité d'antenne maître et de l'unité d'antenne enfant afin de déterminer la position du dispositif associé au signal en comparant (186) une force relative du signal au niveau des première et deuxième antennes pour déterminer un premier angle (b) relativement à un premier axe du bâti d'équipement, ledit premier angle ayant trait au support du dispositif relativement à l'unité d'antenne maître, et en comparant (188) la force relative du signal au niveau des troisième et quatrième antennes afin de déterminer un deuxième angle (a) relativement au premier axe du bâti d'équipement, ledit deuxième angle ayant trait au support du dispositif relativement à la première unité d'antenne enfant.

12. Le système de la revendication 11, comprenant en outre un émetteur sans fil à faible portée configuré pour transmettre le signal transmis.

13. Le système de la revendication 12, dans lequel l'émetteur est configuré pour se coupler soit à un dispositif de centre de données, soit à un câble couplé au dispositif de centre de données.

14. Le système de la revendication 11, comprenant en outre une deuxième unité d'antenne enfant (104, 106, 254, 256) ayant au moins deux antennes (114a, 114b, 116a, 116b) configurées pour détecter le signal transmis et configurées pour transmettre des données à l'unité d'antenne maître.

15. Le système de la revendication 11, dans lequel l'unité d'antenne maître et la première unité d'antenne enfant sont configurées pour être montées dans un bâti d'équipement (100) d'un centre de données.

**FIG. 1**

FIG. 2

FIG. 3

180

┌─────────────────────────────────────────┐  ⌐182
│ RECEIVE A SIGNAL FROM THE DEVICE AT A MASTER │
│ ANTENNA UNIT POSITIONED ON A DATACENTER RACK, │
│ WHEREIN THE MASTER ANTENNA UNIT INCLUDES A │
│ FIRST ANTENNA AND A SECOND ANTENNA │
└─────────────────────────────────────────┘

┌─────────────────────────────────────────┐  ⌐184
│ RECEIVE THE SIGNAL AT A FIRST CHILD ANTENNA UNIT │
│ POSITIONED ON THE DATACENTER RACK, WHEREIN THE │
│ FIRST CHILD ANTENNA UNIT INCLUDES A THIRD │
│ ANTENNA AND A FOURTH ANTENNA │
└─────────────────────────────────────────┘

┌─────────────────────────────────────────┐  ⌐186
│ COMPARE THE RELATIVE STRENGTH OF THE SIGNAL │
│ AT THE FIRST AND SECOND ANTENNAS TO DETERMINE │
│ A FIRST ANGLE │
└─────────────────────────────────────────┘

┌─────────────────────────────────────────┐  ⌐188
│ COMPARE THE RELATIVE STRENGTH OF THE SIGNAL │
│ AT THE THIRD AND FOURTH ANTENNAS TO DETERMINE │
│ A SECOND ANGLE │
└─────────────────────────────────────────┘

┌─────────────────────────────────────────┐  ⌐190
│ DETERMINE A DEVICE LOCATION IN THE RACK USING │
│ THE FIRST AND SECOND ANGLES │
└─────────────────────────────────────────┘

FIG. 4

FIG. 5A

FIG. 5B

FIG. 6

300

302

306

304

FIG. 7

FIG. 8

FIG. 9A

406b   404b

403

404a

406a

402   408

FIG. 9B

450

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005138439 A
- US 2006167624 A
- GB 2383708 A
- US 193109 A
- US 194484 A